# EUROPEAN PATENT APPLICATION

(11) **EP 4 467 611 A1**
(43) Date of publication of application: **27.11.2024**
(21) Application number: 22922156.9
(22) Date of filing: 19.12.2022
(51) Int. Cl.: C08L 83/04, C08K 3/22, C08K 3/28, C08K 3/36, C08K 9/06, C08L 83/06, H01L 23/373

(54) **THERMALLY CONDUCTIVE SILICONE COMPOSITION AND SEMICONDUCTOR DEVICE**

(30) Priority: 18.01.2022 JP 2022006002
(71) Applicant: SHIN-ETSU CHEMICAL CO., LTD., Tokyo 1000005 (JP)
(72) Inventor: TOYA Wataru, Annaka-shi, Gunma 379-0224 (JP); IWATA Mitsuhiro, Annaka-shi, Gunma 379-0224 (JP); YAMADA Kunihiro, Annaka-shi, Gunma 379-0224 (JP); MATSUMURA Kazuyuki, Annaka-shi, Gunma 379-0224 (JP)
(74) Representative: Sonnenhauser, Thomas Martin
(86) International application number: PCT/JP2022/046750
(87) International publication number: WO 2023/140006

(57) **Abstract**

The present invention is a thermal conductive silicone composition including: (A) an organopolysiloxane having a kinematic viscosity at 25°C of 10 to 100,000 mm²/s and not containing an alkoxysilyl group; (B) an organopolysiloxane containing an alkoxysilyl group; (C) one or more thermal conductive fillers selected from irregular-shaped, round, and polyhedral fillers having a thermal conductivity of 10 W/m·K or more; and (D) hydrophobic spherical silica particles having a D₅₀ in a range of 0.005 to 1 um and a D₉₀/D₁₀ of 3 or less in a volume-based particle size distribution and having an average circularity of 0.8 to 1, wherein an amount of the component (C) is 40 to 85% by volume of the entire thermal conductive silicone composition. This provides a thermal conductive silicone composition that has good compressibility even when filled with a large amount of thermal conductive fillers.

## Description

### TECHNICAL FIELD

The present invention relates to a thermal conductive silicone composition and a semiconductor apparatus.

### BACKGROUND ART

It is widely known that semiconductor devices generate heat in use, thereby lowering the performances thereof, and various heat dissipation techniques have been used as a means to solve this problem. A typical heat dissipation technique involves disposing a cooling member (such as a heat sink) near a heat-generating part and bringing them into close contact to efficiently remove and dissipate heat from the cooling member. In this event, if there is a space between the heat-generating member and the cooling member, thermal conductivity is lowered because of the presence of air, which is poor in thermal conduction, so that the temperature of the heat-generating member cannot be reduced sufficiently. To prevent this phenomenon, heat dissipation materials with good thermal conductivity and followability to the surface of the member, such as heat-dissipating grease or heat-dissipating sheets, have been used.

In recent years, the amount of heat generation during operation is further increasing for semiconductors of high-grade devices, such as CPUs for servers, insulated gate bipolar transistors (IGBTs) for driving vehicles, and the like. As the amount of heat generation increases, the heat dissipation performance required for heat-dissipating grease and heat-dissipating sheets has also increased. Improving the heat dissipation performance means lowering the thermal resistance of heat-dissipating grease, heat-dissipating sheets, and the like, and for this purpose, these heat dissipation materials need to be highly filled with thermal conductive fillers. Since the thermal resistance is proportional to thickness, thermal conductive fillers with precisely controlled particle size distribution, which is realized by, for example, removing coarse particles, have been used (Patent Document 1). However, even with the use of thermal conductive fillers with precisely controlled particle size distribution, highly filling the heat dissipation material with such thermal conductive fillers makes it difficult for the heat dissipation material to collapse to a reduced thickness when compressed, resulting in a failure to sufficiently lower the thermal resistance.

### CITATION LIST

### PATENT LITERATURE

Patent Document 1: JP 2019-210305 A

### SUMMARY OF INVENTION

### TECHNICAL PROBLEM

As described above, a need exists for the development of a silicone composition with low thermal resistance.

The present invention has been made under the above circumstances. An object of the present invention is to provide a thermal conductive silicone composition that has good compressibility even when filled with a large amount of thermal conductive fillers.

### SOLUTION TO PROBLEM

To achieve the above object, the present invention provides a thermal conductive silicone composition comprising:
(A) an organopolysiloxane having a kinematic viscosity at 25°C of 10 to 100,000 mm²/s and not containing an alkoxysilyl group;
(B) an organopolysiloxane containing an alkoxysilyl group;
(C) one or more thermal conductive fillers selected from irregular-shaped, round, and polyhedral fillers having a thermal conductivity of 10 W/m·K or more; and
(D) hydrophobic spherical silica particles having a D₅₀ in a range of 0.005 to 1 um and a D₉₀/D₁₀ of 3 or less in a volume-based particle size distribution and having an average circularity of 0.8 to 1, wherein
an amount of the component (C) is 40 to 85% by volume of the entire thermal conductive silicone composition.

This thermal conductive silicone composition has higher thermal conductivity and better compressibility than conventional thermal conductive silicone compositions.

According to the present invention, the component (C) is preferably one or more selected from metal oxides and metal nitrides.

The thermal conductive silicone composition containing such a thermal conductive filler(s) can have even better thermal conductivity and handleability.

Additionally, the component (C) preferably contains an aluminum nitride having a D₅₀ of 4 to 30 um and an irregular-shaped zinc oxide having a D₅₀ of 0.1 to 3 µm.

Such a combination can provide even better thermal conductivity and handleability.

According to the present invention, the component (D) is preferably hydrophobic spherical silica particles having R¹SiO_{3/2} units and R²₃SiO_{1/2} units on surfaces of hydrophilic spherical silica particles comprising a hydrolytic condensate of a tetrafunctional silane compound, a partial hydrolytic condensation product thereof, or a mixture of the two, wherein R¹ is a substituted or unsubstituted monovalent hydrocarbon group of 1 to 20 carbon atoms, and each R² is the same or different and is a substituted or unsubstituted monovalent hydrocarbon group of 1 to 6 carbon atoms.

The use of such hydrophobic spherical silica particles can further improve the compressibility of the thermal conductive silicone composition.

According to the present invention, when the thermal conductive silicone composition with a thickness of 100 um is pressurized at 25°C and 0.1 MPa for 60 minutes, the thickness of the pressurized thermal conductive silicone composition is preferably less than or equal to twice a thickness of the thermal conductive filler in the thermal conductive silicone composition that has the largest D₉₅ in the volume-based particle size distribution.

With the thickness being less than or equal to a predetermined value, the thermal resistance of the thermal conductive silicone composition when compressed can be lowered further.

In another aspect, the present invention provides a semiconductor apparatus comprising the above thermal conductive silicone composition interposed in a space formed between a heating element and a cooling element, the space having a thickness of 100 um or less.

This semiconductor apparatus has the thermal conductive silicone composition, which has higher thermal conductivity than conventional thermal conductive silicone compositions and good compressibility to 100 um or less, interposed in a narrow space between a heating element and a cooling element, and thus has excellent cooling performance.

### ADVANTAGEOUS EFFECTS OF INVENTION

The present invention can provide a thermal conductive silicone composition that has a higher thermal conductivity than conventional thermal conductive silicone compositions, has good compressibility even when loaded with a large amount of thermal conductive fillers, and gives low thermal resistance after compression.

### DESCRIPTION OF EMBODIMENTS

As described above, a need exists for the development of a thermal conductive silicone composition with high thermal conductivity and good compressibility.

The present inventors have earnestly studied to achieve the above object and consequently found that a thermal conductive silicone composition including an organopolysiloxane having a particular kinematic viscosity and not containing an alkoxysilyl group, an organopolysiloxane containing an alkoxysilyl group, a thermal conductive filler(s) having a particular thermal conductivity and shape, and hydrophobic spherical silica particles having a particular particle size distribution and average circularity exhibits good compressibility even when loaded with a large amount of the thermal conductive filler(s). This finding has led to the completion of the present invention.

That is, the present invention is a thermal conductive silicone composition comprising:
(A) an organopolysiloxane having a kinematic viscosity at 25°C of 10 to 100,000 mm²/s and not containing an alkoxysilyl group;
(B) an organopolysiloxane containing an alkoxysilyl group;
(C) one or more thermal conductive fillers selected from irregular-shaped, round, and polyhedral fillers having a thermal conductivity of 10 W/m·K or more; and
(D) hydrophobic spherical silica particles having a D₅₀ in a range of 0.005 to 1 um and a D₉₀/D₁₀ of 3 or less in a volume-based particle size distribution and having an average circularity of 0.8 to 1, wherein
an amount of the component (C) is 40 to 85% by volume of the entire thermal conductive silicone composition.

The present invention is now detailed below; however, the present invention is not limited to the description given below.

### Component (A)

The component (A) is an organopolysiloxane having a kinematic viscosity at 25°C of 10 to 100,000 mm²/s, preferably 30 to 10,000 mm²/s, and not containing an alkoxysilyl group. If the kinematic viscosity of the organopolysiloxane is less than the above lower limit, oil bleeding tends to occur when the organopolysiloxane is formed into grease. On the other hand, if the kinematic viscosity of the organopolysiloxane exceeds the above upper limit, the thermal conductive silicone composition may have poor extensibility. In the present invention, the kinematic viscosity refers to a value measured at 25°C using an Ostwald viscometer.

The component (A) may be any organopolysiloxane having the above kinematic viscosity, and its molecular structure is not limited and may be linear, branched, cyclic, or the like. However, the component (A) is distinguished from the component (B), an organopolysiloxane containing an alkoxysilyl group described below, in that the component (A) does not contain an alkoxysilyl group.

The component (A) is preferably the one represented by the following average composition formula (1).

R⁶ₐSiO_{(4-a)/2} (1)

In the above formula (1), R⁶ independently represents an unsubstituted or substituted monovalent hydrocarbon group of 1 to 18, preferably 1 to 14 carbon atoms. Examples of the monovalent hydrocarbon group include: alkyl groups such as methyl, ethyl, propyl, hexyl, octyl, decyl, dodecyl, tetradecyl, hexadecyl, and octadecyl groups; cycloalkyl groups such as cyclopentyl and cyclohexyl groups; alkenyl groups such as vinyl and allyl groups; aryl groups such as phenyl and tolyl groups; aralkyl groups such as 2-phenylethyl and 2-methyl-2-phenylethyl groups; as well as these groups in which some or all of the hydrogen atoms are substituted with halogen atoms such as fluorine, bromine, and chlorine, a cyano group, or the like, e.g., a 3,3,3-trifluoropropyl group, a 2-(perfluorobutyl)ethyl group, a 2-(perfluorooctyl)ethyl group, and a p-chlorophenyl group.

In the above formula (1), "a" is a number in the range of 1.8 to 2.2, in particular in the range of 1.9 to 2.1. When "a" is within the above range, the resulting silicone composition can have good viscosity required for grease.

The organopolysiloxane represented by the above average composition formula (1) is preferably a linear organopolysiloxane in which the main chain is composed of repeating diorganosiloxane units with both molecular chain ends capped with triorganosiloxy groups, as represented by the following formula (2).

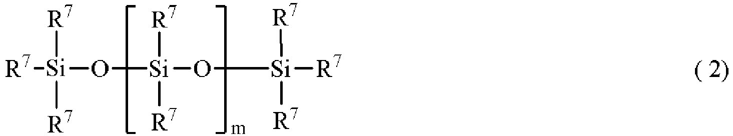

In the above formular (2), R⁷ is independently an unsubstituted or substituted monovalent hydrocarbon group of 1 to 18, preferably 1 to 14 carbon atoms. Examples of the monovalent hydrocarbon group include those mentioned above. In particular, it is preferable that R⁷ at both ends are all methyl groups. "m" is a number that gives the organopolysiloxane a kinematic viscosity at 25°C of 10 to 500,000 mm²/s, preferably 30 to 10,000 mm²/s, and more preferably 100 to 8,000 mm²/s.

The component (A) may be a single component or a mixture of two or more components.

### Component (B)

The component (B) is an organopolysiloxane containing an alkoxysilyl group. The component (B) serves as a surface treatment agent for the component (C), a thermal conductive filler(s) described below, providing a stronger interaction between the components (A), (B) and the thermal conductive filler(s). As a result, the thermal conductive silicone composition can maintain its flowability even when loaded with a large amount of thermal conductive filler(s). It is also possible to inhibit a decrease in heat dissipation performance that may otherwise be caused by oil separation or pumping out over time. Examples of the component (B) include organopolysiloxanes represented by the following general formula (3). In particular, it is preferable to contain a trifunctional hydrolysable organopolysiloxane. 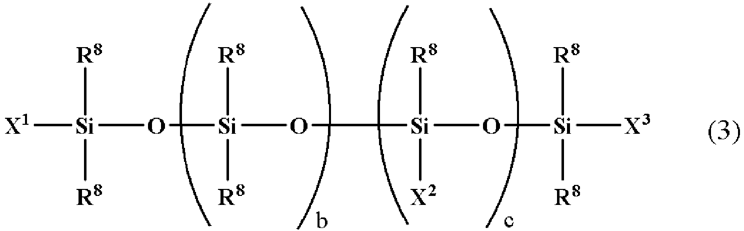 In the formula, R⁸ is independently an unsubstituted or substituted monovalent hydrocarbon group. X¹, X², and X³ is a group represented by R⁸ or - (R⁹)ₙ-SiR¹⁰_{g}(OR¹¹)_{3-g}, where X¹, X², and X³ may be the same or different, but least one of X₁, X₂, and X₃ is -(R⁹)ₙ-SiR¹⁰_{g}(OR¹¹)_{3-g}. R⁹ is an oxygen atom or an alkylene group of 1 to 4 carbon atoms, R¹⁰ is independently an unsubstituted or substituted monovalent hydrocarbon group containing no aliphatic unsaturated bonds, R¹¹ is independently an alkyl group of 1 to 4 carbon atoms, alkoxyalkyl group, alkenyl group, or acyl group, "n" is 0 or 1, "g" is an integer of 0 to 2. "b" and "c" satisfy 1≤b≤1,000 and 0≤c≤1,000, respectively.

In the above formula (3), R⁸ is independently an unsubstituted or substituted monovalent hydrocarbon group of preferably 1 to 10, more preferably 1 to 6, further preferably 1 to 3 carbon atoms. Examples thereof include linear alkyl, branched alkyl, cyclic alkyl, alkenyl, aryl, aralkyl, and halogenated alkyl groups. Examples of the linear alkyl group include methyl, ethyl, propyl, hexyl, and octyl groups. Examples of the branched alkyl group include isopropyl, isobutyl, tert-butyl, and 2-ethylhexyl groups. Examples of the cyclic alkyl group include cyclopentyl and cyclohexyl groups. Examples of the alkenyl group include vinyl and allyl groups. Examples of the aryl group include phenyl and tolyl groups. Examples of the aralkyl group include 2-phenylethyl and 2-methyl-2-phenylethyl groups. Examples of the halogenated alkyl group include 3,3,3-trifluoropropyl, 2-(nonafluorobutyl)ethyl, and 2-(heptadecafluorooctyl)ethyl groups. R⁸ is preferably a methyl, phenyl, or vinyl group.

Examples of the alkylene group of 1 to 4 carbon atoms represented by R⁹ include methylene, ethylene, propylene, and butylene groups. R¹⁰ is independently an unsubstituted or substituted monovalent hydrocarbon group that has preferably 1 to 10, more preferably 1 to 6, further preferably 1 to 3 carbon atoms and that does not contain aliphatic unsaturated bonds. Examples thereof include alkyl groups such as methyl, ethyl, propyl, isopropyl, butyl, isobutyl, tert-butyl, pentyl, neopentyl, hexyl, heptyl, octyl, nonyl, decyl, and dodecyl groups; cycloalkyl groups such as cyclopentyl, cyclohexyl, and cycloheptyl groups; aryl groups such as phenyl, tolyl, xylyl, naphthyl, and biphenylyl groups; aralkyl groups such as benzyl, phenylethyl, phenylpropyl, and methylbenzyl groups; as well as these groups in which some or all of the hydrogen atoms bonded to carbon atoms are substituted with halogen atoms such as fluorine, chlorine, and bromine, a cyano group, or the like.

R¹¹ is independently an alkyl, alkoxyalkyl, alkenyl, or acyl group of 1 to 4 carbon atoms. Examples of the alkyl group represented by R¹¹ include the same alkyl groups of 1 to 4 carbon atoms as those mentioned for R⁸. Examples of the alkoxyalkyl group include methoxyethyl and methoxypropyl groups. Preferable examples of the acyl group represented by R¹¹ include those of 2 to 8 carbon atoms, such as acetyl and octanoyl groups. R¹¹ is preferably an alkyl group, particularly preferably a methyl or ethyl group.

"b" and "c" are as defined above, with b+c being preferably 10 to 1000, more preferably 10 to 300. "n" is 0 or 1, and "g" is an integer of 0 to 2, preferably 0. Note that the number of OR¹¹ groups per molecule is preferably 1 to 6, particularly preferably 3 or 6. Also note that the order of bonding of the siloxane units in parentheses is not limited to that shown below.

Preferable specific examples of the component (B) include the following.

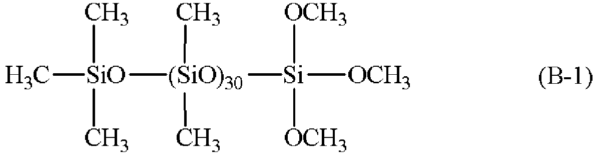

The amount of the component (B) is preferably 10 to 99 mass%, more preferably 50 to 95 mass%, and particularly preferably 70 to 90 mass%, of the total of the components (A) and (B). Containing the component (B) in the amount within this range allows for maintaining good compressibility while preventing deterioration in thermal resistance caused by oil separation or pumping out. Only one kind, or a mixture of two or more kinds of the component (B) may be loaded.

### Component (C)

The component (C) is one or more thermal conductive fillers selected from irregular-shaped, round, and polyhedral fillers having a thermal conductivity of 10 W/m·K or more. If the thermal conductivity is smaller than 10 W/m·K, the thermal conductive silicone composition has insufficient thermal conductivity. While there is no particular upper limit to the thermal conductivity, it is typically around 500 W/m·K.

The shape of the thermal conductive filler is one or more selected from irregular-shaped, round, and polyhedral shapes except spherical shapes. With the thermal conductive filler of any of such shapes, the composition has high thermal conductivity and good compressibility. As used herein, the "round shape" refers to rounded and smooth particles with less corners, not including spherical shapes. The round shape is distinct from spherical shapes in that the round shape has corners. As used herein, the "spherical shape" refers to particles with an average circularity of 0.8 or more. The average circularity can be measured by inputting particle images captured by a scanning electron microscope into an image analyzer, e.g., JSM-7500F available from JEOL Ltd., and performing the following steps. That is, a projection area (X) and a circumferential length (Z) of a particle are measured from the image. Provided that a true circle corresponding to the circumferential length (Z) has an area (Y), the circularity of that particle can be represented as X/Y. Assume a true circle having the same circumferential length as the circumferential length (Z) of the sample particle. Since Z = 2πr and Y = πr², then Y = π × (Z/2π)². Thus, the circularity of an individual particle can be computed as circularity = X/Y = X × 4π/Z². In this way, the circularity is determined for arbitrarily chosen 100 particles, and their average value is reported as an average circularity.

The component (C) has a particle size D₅₀ (median size) preferably in the range of 0.01 to 100 µm, more preferably in the range of 0.1 to 30 um, in a volume-based particle size distribution. With the D₅₀ in this range, the resulting thermal conductive silicone composition has better extensibility and lower thermal resistance when compressed. Note that the particle size distribution of the thermal conductive filler can be measured using a Microtrac MT330 OEX, available from Nikkiso Co., Ltd.

Examples of the thermal conductive filler include aluminum powder, copper powder, silver powder, iron powder, nickel powder, gold powder, tin powder, silicon metal powder, indium powder, gallium powder, diamond powder, alumina powder, zinc oxide powder, aluminum nitride powder, and boron nitride powder. The component (C) may be a single component or a mixture of two or more components. When insulation of electronic components is necessary, the component (C) is preferably one or more selected from metal oxides and metal nitrides, such as aluminum nitride powder, boron nitride powder, alumina powder, and zinc oxide powder.

In particular, the component (C) preferably contains an aluminum nitride having a D₅₀ of 4 to 30 um and an irregular-shaped zinc oxide having a D₅₀ of 0.1 to 3 um. Such a combination provides even better thermal conductivity and handleability of the composition.

The amount of the component (C) is 40 to 85% by volume of the entire thermal conductive silicone composition. If the amount of the component (C) is less than 40% by volume, the resulting thermal conductive silicone composition has low thermal conductivity. If the amount of the component (C) is more than 85% by volume, the resulting thermal conductive silicone composition has too high a viscosity, lowering the processing efficiency.

### Component (D)

The component (D) is hydrophobic spherical silica particles having a D₅₀ in the range of 0.005 to 1 um and a D₉₀/D₁₀ of 3 or less in a volume-based particle size distribution and having an average circularity of 0.8 to 1.

The component (D) adheres to the surface of the component (C) to inhibit an increase in viscosity of the thermal conductive silicone composition. The component (D) also acts as a lubricant for the thermal conductive filler during compression of the thermal conductive silicone composition, improving its compressibility.

The component (D) has a D₅₀ of 0.005 to 1 um, preferably 0.01 to 0.3 um, and particularly preferably 0.01 to 0.25 um. If the D₅₀ is smaller than 0.005 um, particle agglomeration is likely to occur, and if the D₅₀ is greater than 1 µm, the effect of improving the compressibility is lowered.

The component (D) has a D₉₀/D₁₀ ratio of 3 or less, preferably 2.9 or less. If the D₉₀/D₁₀ ratio is greater than 3, the particle size distribution becomes so wide that the effect of improving flowability and compressibility of the thermal conductive silicone composition is lowered. While there is no particular lower limit to the D₉₀/D₁₀ ratio, it may be 1.0, for example.

The D₁₀ and D₉₀ are the particle sizes corresponding to 10% and 90% of the cumulative undersize particles, respectively, in a volume-based particle size distribution. Note that the volume-based particle size distribution of hydrophobic spherical silica particles can be measured using a dynamic light scattering/laser Doppler Nanotrac particle size distribution analyzer (UPA-EX150, available from Nikkiso Co., Ltd.).

The component (D) has an average circularity of 0.8 to 1. As used herein, the term "spherical" shape refers not only to true spheres, but also somewhat distorted spheres. Such "spherical" shapes are evaluated based on the circularity when a particle is projected onto a two-dimensional space, and refer to particles having a circularity of 0.8 to 1. The circularity can be calculated by dividing the circumferential length of a true circle with the same area as a particle by the circumferential length of the particle. The average circularity as referred to in the present invention is an average of 10 particles measured by image analysis of particle images obtained by electron microscopy.

The hydrophobic spherical silica particles of the component (D) are preferably those having R¹SiO_{3/2} units and R²₃SiO_{1/2} units on surfaces of hydrophilic spherical silica particles comprising a hydrolytic condensate of a tetrafunctional silane compound, a partial hydrolytic condensation product thereof, or a mixture of the two, namely hydrophilic spherical silica particles substantially composed of SiO₂ units obtained by hydrolyzing and condensing a tetrafunctional silane compound, a partial hydrolytic condensation product thereof, or a mixture of the two, wherein R¹ is a substituted or unsubstituted monovalent hydrocarbon group of 1 to 20 carbon atoms, and each R² is the same or different and is a substituted or unsubstituted monovalent hydrocarbon group of 1 to 6 carbon atoms.

The above expression of the hydrophilic spherical silica particles being "substantially composed of SiO₂ units" means that the microparticles are basically, but not solely, composed of SiO₂ units and, as is commonly known, have many silanol groups on at least surfaces thereof. In some cases, the above expression also means that a small amount of hydrolyzable groups (hydrocarbyloxy groups) derived from the tetrafunctional silane compound and/or the partial hydrolytic condensation product thereof, which are the raw materials, may remain on the surfaces of or inside the particles without being converted to silanol groups.

As described above, according to the present invention, sol-gel method silica of small particle size obtained by hydrolysis of tetraalkoxysilane is used as a silica raw material (silica before hydrophobization treatment), which is then subjected to specific surface treatment to ensure that the particle size of the resulting powder after hydrophobization treatment maintains the primary particle size of the silica raw material. This prevents agglomeration of these particles.

The silica raw material of any particle size can be obtained by varying reaction conditions, such as using tetraalkoxysilane with a small number of carbon atoms in the alkoxy groups as the silica raw material of small particle size, using alcohol with a small number of carbon atoms as the solvent, increasing the hydrolysis temperature, lowering the concentration of tetraalkoxysilane during hydrolysis, lowering the concentration of the hydrolysis catalyst.

The desired hydrophobic spherical silica particles can be obtained by applying specific surface treatment to the above silica raw material of small particle size, as described above and further detailed below.

One method for producing the above hydrophobic spherical silica particles is now detailed below.

### <Method for Producing the Component (D), Hydrophobic Spherical Silica Particles>

The hydrophobic spherical silica particles used in the inventive thermal conductive silicone composition are obtained by the following steps:
step (D1): synthesis of hydrophilic spherical silica particles,
step (D2): surface treatment with a trifunctional silane compound, and
step (D3): surface treatment with a monofunctional silane compound.

These steps are described below one by one.

### Step (D1): Synthesis of Hydrophilic Spherical Silica Particles

A liquid dispersion of hydrophilic spherical silica particles in a solvent mixture is obtained by hydrolyzing and condensing a tetrafunctional silane compound represented by the following general formula:

Si(OR³)₄ (4)

wherein each R³ is the same or different and is a monovalent hydrocarbon group of 1 to 6 carbon atoms, a partial hydrolytic condensation product thereof, or a mixture of the two in a liquid mixture of a hydrophilic organic solvent and water containing a basic substance.

In the above general formula (4), R³ is a monovalent hydrocarbon group of 1 to 6 carbon atoms, preferably a monovalent hydrocarbon group of 1 to 4, particularly preferably 1 to 2 carbon atoms. Examples of the monovalent hydrocarbon group represented by R³ include alkyl groups such as methyl, ethyl, propyl, and butyl groups; and aryl groups such as a phenyl group. Among these, a methyl, ethyl, propyl, or butyl group is preferred, and a methyl or ethyl group is particularly preferred.

Examples of the tetrafunctional silane compound shown in the above general formula (4) include tetraalkoxysilanes such as tetramethoxysilane, tetraethoxysilane, tetrapropoxysilane, and tetrabutoxysilane, and tetraphenoxysilanes. Among these, tetramethoxysilane, tetraethoxysilane, tetrapropoxysilane, and tetrabutoxysilane are preferred, and tetramethoxysilane and tetraethoxysilane are particularly preferred. Examples of the partial hydrolytic condensation product of the tetrafunctional silane compound shown in the general formula (4) include alkyl silicates such as methyl silicate and ethyl silicate.

The hydrophilic organic solvent is not limited and may be any solvent that dissolves the tetrafunctional silane compound shown in the general formula (4), a partial hydrolytic condensation product thereof, and water. Examples of the solvent include alcohols; cellosolves such as methyl cellosolve, ethyl cellosolve, butyl cellosolve, and cellosolve acetate; ketones such as acetone and methyl ethyl ketone; and ethers such as dioxane and tetrahydrofuran. Among these, alcohols and cellosolves are preferred, and alcohols are particularly preferred. Examples of the alcohols include alcohol shown in the following general formula:

R⁵OH (5)

wherein R⁵ is a monovalent hydrocarbon group of 1 to 6 carbon atoms.

In the above general formula (5), R⁵ is a monovalent hydrocarbon group of preferably 1 to 4, particularly preferably 1 to 2 carbon atoms. Examples of the monovalent hydrocarbon group represented by R⁵ include alkyl groups such as methyl, ethyl, propyl, isopropyl, and butyl groups. Among these, methyl, ethyl, propyl, and isopropyl groups are preferred, and methyl and ethyl groups are particularly preferred. Examples of the alcohol shown in the general formula (5) include methanol, ethanol, propanol, isopropanol, and butanol. Among these, methanol and ethanol are preferred. As the number of carbon atoms in the alcohol increases, the particle size of the produced spherical silica particles increases. Thus, methanol is preferred to obtain the desired small-size silica particles.

Examples of the above basic substance include ammonia, dimethylamine, and diethylamine. Among these, ammonia and dimethylamine are preferred, and ammonia is particularly preferred. A predetermined amount of any of these basic substances may be dissolved in water, and the resulting (basic) aqueous solution may then be mixed with the above hydrophilic organic solvent.

The amount of basic substance used is preferably 0.01 to 2 moles, more preferably 0.02 to 0.5 moles, and particularly preferably 0.04 to 0.12 moles per mol of the total of hydrocarbyloxy groups within the tetrafunctional silane compound represented by the general formula (4) and/or a partial hydrolytic condensation product thereof. The smaller the amount of the basic substance, the desirably smaller the particle size of the silica particles.

The amount of water used in the above hydrolysis and condensation is preferably 0.5 to 5 moles, more preferably 0.6 to 2 moles, and particularly preferably 0.7 to 1 moles per mol of the total of hydrocarbyloxy groups within the tetrafunctional silane compound represented by the general formula (4) and/or a partial hydrolytic condensation product thereof. The ratio of the hydrophilic organic solvent to the water (hydrophilic organic solvent : water) is preferably from 0.5 to 10, more preferably from 3 to 9, and particularly preferably from 5 to 8 by mass. The greater the amount of the hydrophilic organic solvent, the desirably smaller the particle size of the silica particles.

The hydrolysis and condensation of the tetrafunctional silane compound shown in the general formula (4) is performed by a well-known method, namely, by adding the tetrafunctional silane compound shown in the general formula (4) or the like to the mixture of the hydrophilic organic solvent and water containing the basic substance.

The concentration of silica particles in the liquid dispersion of hydrophilic spherical silica particles in the solvent mixture obtained in this step (D1) is typically 3 to 15 mass%, preferably 5 to 10 mass%.

### Step (D2): Surface Treatment with a Trifunctional Silane Compound

A trifunctional silane compound shown in the following general formula:

R¹Si(OR⁴)₃ (7)

wherein R¹ is a substituted or unsubstituted monovalent hydrocarbon group of 1 to 20 carbon atoms, and each R⁴ is the same or different and is a monovalent hydrocarbon groups of 1 to 6 carbon atoms, a partial hydrolytic condensation product thereof, or a mixture of the two is added to the liquid dispersion of hydrophilic spherical silica particles in the solvent mixture obtained in step (D1), thereby treating the surfaces of the hydrophilic spherical silica particles and introducing R¹SiO_{3/2} units, wherein R¹ is as defined above, on the surfaces of the hydrophilic spherical silica particles to obtain a liquid dispersion of first hydrophobic spherical silica particles in the solvent mixture.

This step (D2) is essential for inhibiting the agglomeration of the silica particles in the subsequent concentration step. If such agglomeration cannot be inhibited, individual particles within the resulting silica-based powder are unable to maintain their primary particle size, degrading the effect of improving flowability and collapsibility.

In the above general formula (7), R¹ is a monovalent hydrocarbon group of preferably 1 to 3, particularly preferably 1 to 2 carbon atoms. Examples of the monovalent hydrocarbon group represented by R¹ include alkyl groups such as methyl, ethyl, n-propyl, isopropyl, butyl, and hexyl groups. Among these, a methyl, ethyl, n-propyl, or isopropyl group is preferred, and a methyl or ethyl group is particularly preferred. Some or all of the hydrogen atoms within these monovalent hydrocarbon groups may be substituted with halogen atoms such as fluorine, chlorine, and bromine atoms, preferably with fluorine atoms.

In the above general formula (7), R⁴ is a monovalent hydrocarbon group of preferably 1 to 3, particularly preferably 1 to 2 carbon atoms. Examples of the monovalent hydrocarbon group represented by R⁴ include alkyl groups such as methyl, ethyl, propyl, and butyl groups. Among these, a methyl, ethyl, or propyl group is preferred, and a methyl or ethyl group is particularly preferred.

Examples of the trifunctional silane compound shown in the general formula (7) include unsubstituted or halogen-substituted trialkoxysilanes such as methyltrimethoxysilane, methyltriethoxysilane, ethyltrimethoxysilane, ethyltriethoxysilane, n-propyltrimethoxysilane, n-propyltriethoxysilane, isopropyltrimethoxysilane, isopropyltriethoxysilane, butyltrimethoxysilane, butyltriethoxysilane, hexyltrimethoxysilane, trifluoropropyltrimethoxysilane, and heptadecafluorodecyltrimethoxysilane. Among these, methyltrimethoxysilane, methyltriethoxysilane, ethyltrimethoxysilane, and ethyltriethoxysilane are preferred, and methyltrimethoxysilane and methyltriethoxysilane or partial hydrolytic condensation products thereof are particularly preferred.

The amount added of the trifunctional silane compound shown in the general formula (7) is 0.001 to 1 moles, preferably 0.01 to 0.1 moles, and particularly preferably 0.01 to 0.05 moles per mol of Si atoms within the hydrophilic spherical silica particles used. When the amount added is 0.001 moles or more, the resulting hydrophobic spherical silica particles do not have poor dispersibility, ensuring the effect of improving flowability and collapsibility, and when the amount added is 1 mole or less, there is no risk of agglomeration of the silica particles.

The concentration of silica particles in the liquid dispersion of the first hydrophobic spherical silica particles in the solvent mixture obtained in this step (D2) is typically 3 mass% or more and less than 15 mass%, preferably 5 to 10 mass%. The concentration within this range ensures no decrease in productivity and eliminates the risk of agglomeration of silica particles.

### Concentration Step

A portion of the hydrophilic organic solvent and water is removed from the thus obtained liquid dispersion of the first hydrophobic spherical silica particles in the solvent mixture, thereby concentrating the dispersion to obtain a concentrated liquid dispersion of the first hydrophobic spherical silica particles in the solvent mixture. A hydrophobic organic solvent may be added beforehand (prior to the concentration step) or during the concentration step. In this case, the hydrophobic solvent used is preferably a hydrocarbon- or ketone-based solvent. Specific examples of such solvents include toluene, xylene, methyl ethyl ketone, and methyl isobutyl ketone, with methyl isobutyl ketone being a preferred one. Example methods for removing a portion of the hydrophilic organic solvent and water include distilling-off as well as distilling-off under reduced pressure. The resulting concentrated liquid dispersion preferably has a silica particle concentration of 15 to 40 mass%, more preferably 20 to 35 mass%, and particularly preferably 25 to 30 mass%. The concentration of 15 mass% or more facilitates smooth progress of the subsequent surface treatment step, and the concentration of 40 mass% or less eliminates the risk of agglomeration of the silica particles.

The concentration step is also beneficial in that it inhibits problems associated with the subsequent step (D3), such as that a silazane compound represented by the general formula (8) and a monofunctional silane compound represented by the general formula (9), which are used as surface treatment agents in the step (D3), react with the alcohol or water, resulting in an insufficient surface treatment and an occurrence of agglomeration during subsequent drying, and the resulting silica particles are unable to maintain their primary particle size and less effective in improving flowability and collapsibility.

Step (D3): Surface Treatment with a Monofunctional Silane Compound

A silazane compound shown in the following general formula (8):

R²₃SiNHSiR²₃ (8)

wherein each R² is the same or different and is a substituted or unsubstituted monovalent hydrocarbon group of 1 to 6 carbon atoms, a monofunctional silane compound shown in the following general formula (9):

R²₃SiX (9)

wherein R² is as defined above for the general formula (8), and X is an OH group or a hydrolyzable group, or a mixture of the two is added to the liquid dispersion of the first hydrophobic spherical silica particles in the solvent mixture obtained in step (D2) or the above concentrated liquid dispersion, thereby treating the surfaces of the first hydrophobic spherical silica particles and introducing R²₃SiO_{1/2} units, wherein R² is as defined above for the general formula (8), on the surfaces of the microparticles to obtain second hydrophobic spherical silica particles. The treatment of this step causes residual silanol groups on the surfaces of the first hydrophobic spherical silica particles to undergo triorganosilylation, thereby introducing R²₃SiO_{1/2} units on the particle surfaces.

In the above general formulae (8) and (9), R² is a monovalent hydrocarbon group of preferably 1 to 4, particularly preferably 1 to 2 carbon atoms. Examples of the monovalent hydrocarbon group represented by R² include alkyl groups such as methyl, ethyl, propyl, isopropyl, and butyl groups. Among these, a methyl, ethyl, or propyl group is preferred, and a methyl or ethyl group is particularly preferred. Some or all of the hydrogen atoms within these monovalent hydrocarbon groups may be substituted with halogen atoms such as fluorine, chlorine, and bromine atoms, preferably with fluorine atoms.

Examples of the hydrolyzable group represented by X include chlorine atoms as well as alkoxy, amino, and acyloxy groups. Among these, an alkoxy or amino group is preferred, and an alkoxy group is particularly preferred.

Examples of the silazane compounds shown in the general formula (8) include hexamethyldisilazane and hexaethyldisilazane, with hexamethyldisilazane being a preferred one. Examples of the monofunctional silane compound shown in the general formula (9) include monosilanol compounds such as trimethylsilanol and triethylsilanol; monochlorosilanes such as trimethylchlorosilane and triethylchlorosilane; monoalkoxysilanes such as trimethylmethoxysilane and trimethylethoxysilane; monoaminosilanes such as trimethylsilyldimethylamine and trimethylsilyldiethylamine; and monoacyloxysilanes such as trimethylacetoxysilane. Among these, trimethylsilanol, trimethylmethoxysilane, or trimethylsilyldiethylamine is preferred, and trimethylsilanol or trimethylmethoxysilane is particularly preferred.

The amount of silazane compound and/or monofunctional silane compound used is 0.1 to 0.5 moles, preferably 0.2 to 0.4 moles, and particularly preferably 0.25 to 0.35 moles per mol of Si atoms within the hydrophilic spherical silica particles used. When the amount used is 0.1 moles or more, the resulting hydrophobic spherical silica particles do not have poor dispersibility, and when the amount used is 0.5 moles or less, there is no adverse effect on the economics of the process.

The above hydrophobic spherical silica particles are converted into a powder using a normal method such as drying under normal pressure or drying under reduced pressure.

The amount of the component (D) loaded is preferably 0.01 to 10 mass%, more preferably 0.05 to 5 mass%, and even more preferably 0.1 to 3 mass% of the component (C). Such a range provides an excellent effect of improving the flowability and compressibility of the thermal conductive silicone composition.

### Other Components

To prevent deterioration of the thermal conductive silicone composition, the inventive thermal conductive silicone composition may be loaded with an antioxidant such as 2,6-di-t-butyl-4-methylphenol, if necessary. The thermal conductive silicone composition may further be loaded with a dye, a pigment, a flame retardant, a precipitation-inhibitor, a thixotropy-enhancer, or the like.

### Thermal Conductive Silicone Composition

The inventive thermal conductive silicone composition contains the above components (A) through (D), where the amount of the component (C) is 40 to 85% by volume of the entire thermal conductive silicone composition, and has good compressibility. When the thermal conductive silicone composition with a thickness of 100 um is pressurized at 25°C and 0.1 MPa for 60 minutes, the thickness of the pressurized thermal conductive silicone composition is preferably less than or equal to twice a thickness of the thermal conductive filler in the thermal conductive silicone composition that has the largest D₉₅ in the volume-based particle size distribution. An example method for measuring the thickness after the pressurization is as described in Examples below. The D₉₅ as referred to herein is a particle size corresponding to 95% of the cumulative undersize particles in a volume-based particle size distribution.

The inventive thermal conductive silicone composition has both high thermal conductivity and good compressibility and thus has low thermal resistance. The thermal conductive silicone composition has a thermal resistance of preferably 7.0 mm²·K/W or less, more preferably 6.5 mm²·K/W or less, and even more preferably 5.0 mm²·K/W or less, as measured at 25°C by a laser flash method. While there is no particular lower limit, it may be, for example, 0.1 mm²·K/W given the physical feasibility. Note that an example method for measuring the thermal resistance is as detailed in Examples below.

The inventive thermal conductive silicone composition has an absolute viscosity of preferably 3 to 500 Pa·s, more preferably 10 to 400 Pa·s, as measured at 25°C. The absolute viscosity of 3 Pa·s or more allows the shape to be easily maintained, which improves the processing efficiency. Meanwhile, the absolute viscosity of 500 Pa·s or less allows the composition to be easily ejected, which improves the processing efficiency as well. The absolute viscosity can be adjusted through the formulation of the above components. In the present invention, the absolute viscosity refers to a value measured at 25°C using, for example, a spiral viscometer (type PC-1T) available from Malcom Co., Ltd. (at 10 rpm with rotor A, shear rate of 6[1/s]).

### Semiconductor Apparatus

The inventive semiconductor apparatus has the inventive thermal conductive silicone composition interposed in a space formed between a heating element, such as an LSI or any other electronic component, and a cooling element, where the space has a thickness of 100 um or less. The inventive thermal conductive silicone composition is compressed to a thickness of 100 um or less. This is expected to improve the cooling efficiency over conventional thermal conductive silicone compositions. While there is no particular lower limit to the thickness, it may be 5 µm, for example.

There is no particular limitation to the method for manufacturing the inventive semiconductor apparatus. However, in order to make the thickness of the thermal conductive silicone composition 100 um or less, the inventive semiconductor apparatus is assembled preferably at the pressure of 0.1 Mpa or more, further preferably at the pressure of 4.0 Mpa or more. Increasing the pressure during pressurizing the thermal conductive silicone composition can reduce the time required for the compression.

### Method for Producing Thermal Conductive Silicone Composition

A non-limiting method for producing the inventive thermal conductive silicone composition is now described.

The method for producing the inventive thermal conductive silicone composition is not limited and may follow any conventional thermal conductive silicone composition producing method. For example, the inventive thermal conductive silicone composition can be produced by mixing the above components (A) to (D) and, if necessary, other components using a mixer such as Trimix, Twinmix, or Planetary Mixer (all registered trademarks for mixers available from Inoue Manufacturing Co., Ltd.), Ultramixer (a registered trademark for a mixer available from Mizuho Industrial Co., Ltd.), and Hivis Disper Mix (a registered trademark for a mixer available from PRIMIX Corporation).

### EXAMPLE

The present invention is now further detailed with reference to Examples and Comparative Examples, though the present invention is not limited to Examples give below. In the following description, the kinetic viscosity is a value measured at 25°C with an Ostwald viscometer (available from Sibata Scientific Technology Ltd.).

### Synthesis Example 1

### Step (D1): Synthesis of Hydrophilic Spherical Silica Particles

1,045.7 g of methanol, 112.6 g of water, and 33.2 g of 28 mass% ammonia water were fed and mixed in a 3 L glass reactor equipped with a stirrer, a dropping funnel, and a thermometer. This solution was adjusted to 35°C while being stirred, and 436.5 g of tetramethoxysilane (2.87 moles) was dropped thereto for 6 hours. After completion of the dropping, the solution was stirred for further 0.5 hours for hydrolysis, resulted in a suspension of hydrophilic spherical silica particles.

### Step (D2): Surface Treatment with a Trifunctional Silane Compound

4.4 g of methyltrimethoxysilane (0.03 moles) was dropped to the suspension obtained in the above step at room temperature for 0.5 hours. After the dropping, the stirring of the suspension was maintained for 12 hours to apply hydrophobic treatment to the surfaces of the silica particles. This resulted in a liquid dispersion of hydrophobic spherical silica particles.

Then, an ester adapter and a condenser tube were attached to the glass reactor, and the liquid dispersion obtained in the previous step was heated to 60 to 70°C to distill off 1,021 g of the mixture of methanol and water. This resulted in a concentrated liquid dispersion of hydrophobic spherical silica particles in the solvent mixture. The content of hydrophobic spherical silica particles in the concentrated liquid dispersion was 28 mass%.

### Step (D3): Surface Treatment with a Monofunctional Silane Compound

138.4 g of hexamethyldisilazane (0.86 moles) was added at room temperature to the concentrated liquid dispersion obtained in the previous step. The liquid dispersion was then heated to 50 to 60°C and made to react for 9 hours, thus trimethylsilylating the silica particles in the liquid dispersion. Then, the solvent in the liquid dispersion was distilled off at 130°C and under reduced pressure (6,650 Pa) to obtain 188 g of hydrophobic spherical silica particles (D-1).

The hydrophilic spherical silica particles obtained in step (D1) were analyzed by Measurement Method 1 described below. The hydrophobic spherical silica particles obtained through steps (D1) to (D3) were analyzed by Measurement Methods 2 and 3 described below. The results are shown in Table 1.

### Measurement Methods 1 to 3

### 1. Measurement of Particle Size of Hydrophilic Spherical Silica Particles Obtained in Step (D1)

The suspension of hydrophilic spherical silica particle was added to methanol to give a concentration of hydrophilic spherical silica particles of 0.5 mass%. The suspension was then subjected to ultrasound for 10 minutes to disperse the particles. The particle size distribution of the thus treated particles was measured using a dynamic light scattering/laser Doppler Nanotrac particle size distribution analyzer (UPA-EX150, available from Nikkiso Co., Ltd.), and the volume-based median size was reported as the particle size. Note that the median size refers to a particle size corresponding to cumulative 50% when the particle size distribution is expressed as a cumulative distribution.

### 2. Measurement of Particle Size and Particle Size Distribution D₉₀/D₁₀ of Hydrophobic Spherical Silica Particles Obtained in Step (D3)

The hydrophobic spherical silica particles were added to methanol to give a concentration of hydrophobic spherical silica particles of 0.5 mass%. The solution was then subjected to ultrasound for 10 minutes to disperse the particles. The particle size distribution of the thus treated particles was measured using a dynamic light scattering/laser Doppler Nanotrac particle size distribution analyzer (UPA-EX150, available from Nikkiso Co., Ltd.), and the volume-based median size was reported as the particle size. To measure the particle size distribution D₉₀/D₁₀, the particle sizes corresponding to 10% and 90% of the cumulative undersize particles were reported as D₁₀ and D₉₀, respectively, in the above distribution for particle size measurement, and the D₉₀/D₁₀ was calculated from the measured values.

### 3. Circularity of Hydrophobic Spherical Silica Particles

Particles were observed with an electron microscope (S-4700, available from Hitachi, Ltd., magnifying power: 10⁵) to determine their circularity when projected onto a two-dimensional space, where the circularity was defined as the circumferential length of a true circle with the same area as a particle divided by the circumferential length of the particle. An average of measurements of 10 particles was reported as the circularity.

### Synthesis Example 2

### Step (D1): Synthesis of Hydrophilic Spherical Silica Particles

623.7 g of methanol, 41.4 g of water, and 49.8 g of 28 mass% ammonia water were fed and mixed in a 3 L glass reactor equipped with a stirrer, a dropping funnel, and a thermometer. This solution was adjusted to 35°C while being stirred, and the addition of 1,163.7 g of tetramethoxysilane and 418.1 g of 5.4 mass% ammonia water to the solution was commenced simultaneously, with the former being dropped thereto for 6 hours and the latter for 4 hours. After the dropping of tetramethoxysilane, the solution was stirred for further 0.5 hours for hydrolysis, resulted in a suspension of hydrophilic spherical silica particles.

### Step (D2): Surface Treatment with a Trifunctional Silane Compound

11.6 g of methyltrimethoxysilane (equivalent to 0.01 in molar ratio to tetramethoxysilane) was dropped to the thus obtained suspension at room temperature for 0.5 hours. After the dropping, the suspension was stirred for 12 hours to treat the surfaces of the silica particles.

An ester adapter and a condenser tube were attached to the glass reactor, and 1,440 g of methyl isobutyl ketone was added to the liquid dispersion containing the above surface-treated silica particles. The dispersion was then heated to 80 to 110°C to distill off methanol and water over 7 hours.

### Step (D3): Surface Treatment with a Monofunctional Silane Compound

357.6 g of hexamethyldisilazane was added at room temperature to the thus obtained liquid dispersion. The dispersion was then heated to 120°C and made to react for 3 hours, thus the silica particles was trimethylsilylated. Then, the solvent was distilled off under reduced pressure to obtain 472 g of hydrophobic spherical silica particles (D-2).

The thus obtained silica particles were analyzed in the same manner as in Synthesis Example 1. The results are shown in Table 1.

**[Table 1]**

| | Synthesis Example 1 | Synthesis Example 2 |
|---|---|---|
| Hydrophobic spherical silica particles | D-1 | D-2 |
| Particle size¹⁾ (nm) | 11 | 115 |
| Particle size²⁾ (nm) | 11 | 115 |
| D₉₀/D₁₀ | 2.4 | 2.2 |
| Circularity | 0.92 | 0.90 |

| | | |
|---|---|---|
| <Note> 1) Particle size of the hydrophilic spherical silica particles in the liquid dispersion obtained in step (D1) 2) Particle size of the final hydrophobic spherical silica particles | | |

The components used are as follows.

### Component (A)

A-1: Dimethylpolysiloxane capped at both ends with trimethylsilyl groups and having a kinematic viscosity at 25°C of 5,000 mm²/s (relative density: 1.00).

### Component (B)

Hydrolyzable organopolysiloxane shown in the following formula (relative density: 1.00):

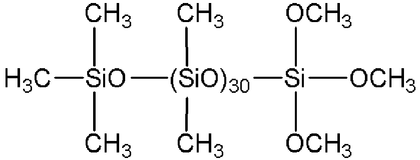

### Component (C)

C-1: Round aluminum nitride powder having a D₅₀ of 5.0 um and a D₉₅ of 12.0 um (200 W/m·K, relative density: 3.26) C-2: Round aluminum nitride powder having a D₅₀ of 20.0 um and a D₉₅ of 50.0 µm (200 W/m·K, relative density: 3.26)

C-3: Irregular-shaped zinc oxide powder having a D₅₀ of 1.3 um and a D₉₅ of 3.5 um (40 W/m·K, relative density: 5.67)

C-4: Irregular-shaped zinc oxide powder having a D₅₀ of 2.0 um and a D₉₅ of 3.0 um (40 W/m·K, relative density: 5.67)

C-5: Spherical aluminum nitride powder having a D₅₀ of 5.4 um and a D₉₅ of 14.0 um (200 W/m·K, relative density: 3.26) (comparative component)

### Component (D)

D-1: Hydrophobic spherical silica particles obtained in Synthesis Example 1 (relative density: 1.80) D-2: Hydrophobic spherical silica particles obtained in Synthesis Example 2 (relative density: 1.80) D-3: Hydrophobic spherical silica particles having a D₅₀ of 16.0 nm and a D₉₀/D₁₀ of 3.4 and having a circularity of 0.65 (relative density: 1.80) (comparative component)

### Examples 1 to 4 and Comparative Examples 1 to 5

### <Preparation of Thermal Conductive Silicone Compositions>

Respective thermal conductive silicone compositions were prepared by formulating the above components (A) to (D) in the amounts shown in Table 2 below using the following method.

The components (A), (B), (C), and (D) were added to a 5 L planetary mixer (available from Inoue Mfg., Inc.) and mixed at 170°C for 1.5 hours. The mixture was then cooled to room temperature, thus preparing the respective thermal conductive silicone compositions.

For each of the thus obtained thermal conductive silicone compositions, the viscosity, thermal conductivity, minimum thickness, and thermal resistance were measured using the following method. The results are shown in Table 2.

### Viscosity

The absolute viscosity of each thermal conductive silicone composition was measured at 25°C and at the rotation speed of 10 rpm, using a spiral viscometer (type PC-1T) available from Malcom Co., Ltd.

### Thermal Conductivity

Each thermal conductive silicone composition was wrapped in kitchen wrap into a drawstring bag-like form, and the thermal conductivity of the composition in this form was measured using TPA-501, available from Kyoto Electronics Industry Co., Ltd.

### Minimum Thickness

Each thermal conductive silicone composition with a thickness of 100 um was sandwiched between two circular, 12.6-mm-diameter and 1-mm-thick aluminum plates and pressurized at 25°C and 0.1 MPa for 60 minutes using an autograph AG-5KNZPLUS, available from Shimadzu Corporation, to produce each test sample. Then, the thickness of each test sample was measured using a micrometer (available from Mitutoyo Corporation), from which the thickness of the aluminum plates was subtracted to determine the minimum thickness of each thermal conductive silicone composition after the compression.

### Measurement of Thermal Resistance

Using the above test samples after the compression, the thermal resistance of each thermal conductive silicone composition was measured at 25°C using a thermal resistance measuring instrument based on a laser flash method (a xenon flash analyzer LFA447 NanoFlash, available from Netzch).

**[Table 2]**

| | | Ex. 1 | Ex. 2 | Ex. 3 | Ex. 4 | Comp. Ex. 1 | Comp. Ex. 2 | Comp. Ex. 3 | Comp. Ex. 4 | Comp. Ex. 5 |
|---|---|---|---|---|---|---|---|---|---|---|
| | A-1 | 30 | 10 | 10 | 30 | 30 | 30 | 10 | 10 | 30 |
| | B-1 | 70 | 90 | 90 | 70 | 70 | 70 | 90 | 90 | 70 |
| | C-1 | 800 | 0 | 0 | 800 | 800 | 800 | 0 | 0 | 0 |
| | D₉₅ = 12.0µm | | | | | | | | | |
| | C-2 | 0 | 940 | 0 | 0 | 0 | 0 | 940 | 0 | 0 |
| | D₉₅ = 50.0µm | | | | | | | | | |
| | C-3 | 400 | 630 | 100 | 400 | 400 | 400 | 630 | 100 | 400 |
| | D₉₅ = 3.5µm | | | | | | | | | |
| | C-4 D₉₅ = 3.0µm | 0 | 0 | 370 | 0 | 0 | 0 | 0 | 370 | 0 |
| Composition (mass) | C-5 (Comparative component) | 0 | 0 | 0 | 0 | 0 | 0 | 0 | 0 | 800 |
| | D₉₅ = 14.0µm | | | | | | | | | |
| | D-1 | 0 | 0 | 0 | 1.0 | 0 | 0 | 0 | 0 | 0 |
| | D-2 | 1.0 | 1.5 | 0.5 | 0 | 0 | 0 | 0 | 0 | 1.0 |
| | D-3(Comparative component) | 0 | 0 | 0 | 0 | 0 | 1.0 | 0 | 0 | 0 |
| | Volume ratio of component (C) (%) | 75.9 | 79.8 | 45.3 | 75.9 | 76.0 | 75.9 | 80.0 | 45.3 | 16.9 |
| Evaluation results | Viscosity (Pa·s) | 270 | 200 | 40 | 250 | 280 | 480 | 400 | 60 | 350 |
| | Thermal conductivity (W/m·K) | 4.7 | 7.6 | 1.2 | 4.7 | 4.7 | 4.7 | 7.8 | 1.2 | 3.3 |
| | Min. thickness when compressed (µm) | 20 | 50 | 5 | 22 | 30 | 40 | 80 | 10 | 48.0 |
| | Min. thickness when compressed/ Max. D₉₅ of component (C) | 1.7 | 1.0 | 1.7 | 1.8 | 2.5 | 3.3 | 1.6 | 3.3 | 3.4 |
| | Thermal resistance when compressed (mm²·K/W) | 4.8 | 6.2 | 6.4 | 5.0 | 7.1 | 7.7 | 10.0 | 8.7 | 19.0 |

As shown in Table 2, the thermal conductive silicone compositions of Examples 1 to 4 have good compressibility and low thermal resistance while having high thermal conductivity.

On the other hand, Comparative Examples 1, 3, and 4, which did not contain the component (D), and Comparative Example 2, which used hydrophobic silica particles with a D₉₀/D₁₀ exceeding the range of the present invention in place of the component (D) of the present invention, have higher thermal resistance due to inferior compressibility.

Comparative Example 5, in which a part of the component (C) of Example 1 was replaced with a spherical thermal conductive filler, has poor thermal conductivity and compressibility compared to Example 1.

It should be noted that the present invention is not limited to the above-described embodiments. The embodiments are just examples, and any examples that substantially have the same feature and demonstrate the same functions and effects as those in the technical concept disclosed in claims of the present invention are included in the technical scope of the present invention.

## Claims

1. A thermal conductive silicone composition comprising:
(A) an organopolysiloxane having a kinematic viscosity at 25°C of 10 to 100,000 mm²/s and not containing an alkoxysilyl group;
(B) an organopolysiloxane containing an alkoxysilyl group;
(C) one or more thermal conductive fillers selected from irregular-shaped, round, and polyhedral fillers having a thermal conductivity of 10 W/m·K or more; and
(D) hydrophobic spherical silica particles having a D₅₀ in a range of 0.005 to 1 um and a D₉₀/D₁₀ of 3 or less in a volume-based particle size distribution and having an average circularity of 0.8 to 1, wherein
an amount of the component (C) is 40 to 85% by volume of the entire thermal conductive silicone composition.

2. The thermal conductive silicone composition according to claim 1, wherein the component (C) is one or more selected from metal oxides and metal nitrides.

3. The thermal conductive silicone composition according to claim 2, wherein the component (C) contains an aluminum nitride having a D₅₀ of 4 to 30 um and an irregular-shaped zinc oxide having a D₅₀ of 0.1 to 3 µm.

4. The thermal conductive silicone composition according to any one of claims 1 to 3, wherein the component (D) is hydrophobic spherical silica particles having R¹SiO_{3/2} units and R²₃SiO_{1/2} units on surfaces of hydrophilic spherical silica particles comprising a hydrolytic condensate of a tetrafunctional silane compound, a partial hydrolytic condensation product thereof, or a mixture of the two, wherein R¹ is a substituted or unsubstituted monovalent hydrocarbon group of 1 to 20 carbon atoms, and each R² is the same or different and is a substituted or unsubstituted monovalent hydrocarbon group of 1 to 6 carbon atoms.

5. The thermal conductive silicone composition according to any one of claims 1 to 4, wherein when the thermal conductive silicone composition with a thickness of 100 um is pressurized at 25°C and 0.1 MPa for 60 minutes, the thickness of the pressurized thermal conductive silicone composition is less than or equal to twice a thickness of the thermal conductive filler in the thermal conductive silicone composition that has the largest D₉₅ in the volume-based particle size distribution.

6. A semiconductor apparatus comprising the thermal conductive silicone composition according to any one of claims 1 to 5 interposed in a space formed between a heating element and a cooling element, the space having a thickness of 100 um or less.
